# EUROPEAN PATENT APPLICATION

(11) **EP 4 752 920 A1**
(43) Date of publication of application: **03.06.2026**
(21) Application number: 25217903.1
(22) Date of filing: 24.11.2025
(51) Int. Cl.: H01F 27/36

(54) **MAGNETIC SHIELDING ASSEMBLY, MAGNETIC ATTRACTION ASSEMBLY, WIRELESS CHARGING DEVICE, AND ELECTRONIC DEVICE**

(30) Priority: 26.11.2024 CN 202411711146
(71) Applicant: GUANGDONG OPPO MOBILE TELECOMMUNICATIONS CORP., LTD., Dongguan, Guangdong 523860 (CN)
(72) Inventor: CHEN, Yijun, Dongguan, 523860 (CN)
(74) Representative: Novagraaf Technologies

(57) **Abstract**

A magnetic shielding assembly includes: a first magnetic shielding member (10); a second magnetic shielding member (20), disposed at a side of the first magnetic shielding member (10), where a first gap (101) is formed between the first magnetic shielding member (10) and the second magnetic shielding member (20); and a third magnetic shielding member (30), disposed at a side of the first magnetic shielding member (10) opposite to the second magnetic shielding member (20), where a second gap (102) is formed between the first magnetic shielding member (10) and the third magnetic shielding member (30); and the first magnetic shielding member (10), the second magnetic shielding member (20), and the third magnetic shielding member (30) cooperatively define a receiving slot (103).

## Description

### TECHNICAL FIELD

Embodiments of the present disclosure relate to the technical field of electrics, and more specifically, to a magnetic shielding assembly, a magnetic attraction assembly, a wireless charging device, and an electronic device.

### BACKGROUND

A wireless charging device is configured to charge an electronic device (such as a mobile phone and a tablet computer). A transmitter-side wireless charging module (TX) of the wireless charging device transmits energy with a receiver-side wireless charging module (RX) of the electronic device through respective coils, such that wireless charging is achieved. In order to ensure precise alignment between the coils of the wireless charging device and the coils of the electronic device, magnets may be arranged on both the wireless charging device and the electronic device, such that the coils of the wireless charging device may be accurately aligned with the coils of the electronic device, and the electronic device may be magnetically attached to the wireless charging device. In this way, misalignment between the coils of the wireless charging device and the coils of the electronic device may be avoided, and a charging efficiency and a charging speed of the wireless charging device may not be affected. However, magnetic flux lines generated by the magnets at the transmitter side may not fully converge onto the magnets of the receiver side, and part of the magnetic flux lines may inevitably escape. Consequently, the part of the magnetic flux lines may reach a magnetic core (such as a nanocrystalline core) of the receiver-side wireless charging module and/or a magnetic core of the transmitter-side wireless charging module, such that a bias magnetic field may be generated within the magnetic core. In this case, a magnetic flux density during practical operation may approach a saturation magnetic flux density Bs, and that is, magnetic saturation may occur easily, and the charging efficiency of the electronic device may be reduced.

### SUMMARY

The present disclosure provides a magnetic shielding assembly. When the magnetic shielding assembly is arranged in the wireless charging device and in an electronic device, a wireless charging efficiency may be increased.

In a first aspect, the present disclosure provides a magnetic shielding assembly, including the following: a first magnetic shielding member; a second magnetic shielding member, disposed at a side of the first magnetic shielding member, where a first gap is formed between the first magnetic shielding member and the second magnetic shielding member; and a third magnetic shielding member, disposed at a side of the first magnetic shielding member opposite to the second magnetic shielding member, where a second gap is formed between the first magnetic shielding member and the third magnetic shielding member; and the first magnetic shielding member, the second magnetic shielding member, and the third magnetic shielding member cooperatively define a receiving slot.

In a second aspect, the present disclosure provides a magnetic attraction assembly, including: the magnetic shielding assembly according to the first aspect; and a magnet received in the receiving slot of the magnetic shielding assembly.

In a third aspect, the present disclosure provides a wireless charging device, including: a transmitter-side wireless charging module; and a magnetic attraction assembly according to the second aspect, where the magnetic attraction assembly surrounds an outer periphery of the transmitter-side wireless charging module.

In a fourth aspect, the present disclosure provides an electronic device, including: a receiver-side wireless charging module; and a magnetic attraction assembly according to the second aspect, where the magnetic attraction assembly surrounds an outer periphery of said receiver-side wireless charging module.

According to the present disclosure, the magnetic shielding assembly may include a second magnetic shielding member, a first magnetic shielding member, and a third magnetic shielding member, which are sequentially arranged and are spaced apart from each other. The first magnetic shielding member, the second magnetic shielding member, and the third magnetic shielding member cooperatively form a receiving slot to receive a magnet. When the magnetic shielding assembly of the present disclosure is arranged in a wireless charging device to receive a transmitter-side magnet of the wireless charging device, leakage of magnetic flux lines generated by the transmitter-side magnet may be prevented, preventing any part of the magnetic flux lines generated by the transmitter-side magnet from reaching a magnetic core of the wireless charging device and a magnetic core of the electronic device. In this way, a bias magnetic field generated within the magnetic core of the transmitter-side magnetic and the magnetic core of the receiver-side magnetic may be reduced, anti-saturation performance of the magnetic core of the transmitter-side magnetic and the magnetic core of the receiver-side magnetic may be improved, an inductance and a coupling efficiency of the magnetic core of the transmitter-side magnetic and the magnetic core of the receiver-side magnetic may be improved, and therefore, a charging efficiency of the wireless charging device may be increased. Similarly, when the magnetic shielding assembly of the present disclosure is arranged in electronic devices to receive the receiver-side magnet, leakage of magnetic flux lines generated by the receiver-side magnet core of may be reduced, preventing any part of the magnetic flux lines from reaching the transmitter-side magnetic core of the wireless charging device and the receiver-side magnetic core of the electronic device. The bias magnetic field generated within the transmitter-side magnetic core and the receiver-side magnetic core may be reduced, the anti-saturation performance of the transmitter-side magnetic core and the receiver-side magnetic core may be improved, the inductance and the coupling efficiency of the transmitter-side magnetic core and the receiver-side magnetic core may be improved, and therefore, the wireless charging efficiency may be increased. Furthermore, a first gap may be formed between the first magnetic shielding member and the second shielding isolation member, and a second gap may be formed between the first magnetic shielding member and the third magnetic shielding member. Compared to configurations where the first magnetic shielding member, the second magnetic shielding member, and the third magnetic shielding member sequentially abut or connect to each other, the magnetic shielding assembly of the present disclosure achieves better magnetic shielding performance. When receiving the magnet, leakage of the magnetic flux lines generated by the magnet received in the receiving slot may be prevented optimally, the bias magnetic field generated within the transmitter-side magnetic core and the receiver-side magnetic core may be reduced better, the anti-saturation performance of the transmitter-side magnetic core and the receiver-side magnetic core may be improved better, and the inductance and the coupling efficiency of may be improved better, and the wireless charging efficiency may be increased.

### BRIEF DESCRIPTION OF THE DRAWINGS

In order to more clearly illustrate technical solutions of embodiments of the present disclosure, drawings for the embodiments will be briefly introduced below. Apparently, the drawings described below merely represent some embodiments of the present disclosure. Any ordinary skilled artisan shall obtain other drawings based on the following drawings without any creative work.
FIG. 1 is a structural schematic view of a magnetic shielding assembly according to an embodiment of the present disclosure.
FIG. 2 is a structural schematic view of the magnetic shielding assembly, being viewed from another viewing angle, according to an embodiment of the present disclosure.
FIG. 3 is a structural plan view of the magnetic shielding assembly according to an embodiment of the present disclosure.
FIG. 4 is an enlarged view of a structure in a dashed-line block I in FIG. 3.
FIG. 5 is a cross-sectional view of the magnetic shielding assembly, taken along a line A-A in FIG. 3, according to an embodiment of the present disclosure.
FIG. 6 is an enlarged view of a structure in a dashed-line block II in FIG. 5.
FIG. 7 is a structural schematic view of a magnetic attraction assembly according to an embodiment of the present disclosure.
FIG. 8 is an exploded view of the magnetic attraction assembly according to an embodiment of the present disclosure.
FIG. 9 is a structural schematic view of a magnet according to an embodiment of the present disclosure.
FIG. 10 is a structural plan view of the magnetic attraction assembly according to an embodiment of the present disclosure.
FIG. 11 is a cross-sectional view of the magnetic attraction assembly, taken along a line B-B in FIG. 10, according to an embodiment of the present disclosure.
FIG. 12 is an enlarged view of a structure in a dashed-line block III in FIG. 11.
FIG. 13 is a structural schematic view of a wireless charging device according to an embodiment of the present disclosure.
FIG. 14 is an exploded view of the wireless charging device according to an embodiment of the present disclosure.
FIG. 15 is a circuit block diagram of the wireless charging device according to an embodiment of the present disclosure.
FIG. 16 is a structural schematic view of an electronic device according to an embodiment of the present disclosure.
FIG. 17 is a structural schematic view showing arrangement of a receiver-side wireless charging module and a receiver-side magnetic attraction assembly in the electronic device according to an embodiment of the present disclosure.
FIG. 18 is a circuit block diagram of the electronic device according to an embodiment of the present disclosure.
FIG. 19(a) is a magnetic field distribution cloud map of a receiver-side magnetic core for the Embodiment 2.
FIG. 19(b) is a magnetic field distribution cloud map of a receiver-side magnetic core for the Embodiment 4.
FIG. 19(c) is a magnetic field distribution cloud map of a receiver-side magnetic core for the Embodiment 5.
FIG. 19(d) is a magnetic field distribution cloud map of a receiver-side magnetic core for the Embodiment 7.
FIG. 20(a) is a magnetic field distribution cloud map of the receiver-side magnetic core for the Control Embodiment 1.
FIG. 20(b) is a magnetic field distribution cloud map of the receiver-side magnetic core for the Control

### Embodiment 2.

### Reference numerals in the drawings:

100-magnetic shielding assembly, 10-first magnetic shielding member, 11-first sub-notch, 20-second magnetic shielding member, 21-second sub-notch, 30-third magnetic shielding member, 31-third sub-notch, 101-first gap, 102-second gap, 103-receiving slot, 104-notch, 200-magnetic attraction assembly, 210-magnet, 211-sub-magnet assembly, 2111-sub-magnet, 300-wireless charging device, 310-transmitter-side wireless charging module, 311-transmitter-side coil, 312-transmitter-side magnetic core, 320-first processor, 330-first memory, 340-housing, 350-cover plate, 341-mounting space, 400-electronic device, 410-receiver-side wireless charging module, 411- receiver-side coil, 412- receiver-side magnetic core, 420-second processor, 430-second memory, 440-display screen, 450-power supply module.

### DETAILED DESCRIPTIONS

In order to enable any ordinary skilled artisan to better understand the technical solutions of the present disclosure, the technical solutions described in the embodiments of the present disclosure will be clearly and completely described below by referring to the accompanying drawings. It should be understood that the embodiments described herein represent only a portion of, not all of, the embodiments of the present disclosure. All other embodiments, which are obtained by any ordinary skilled artisan based on the embodiments of the present disclosure without making any creative work, shall fall within the scope of the present disclosure.

The terms "first", "second", and similar designations used in the specification, claims, and accompanying drawings of the present disclosure are intended to distinguish different objects and do not imply any particular sequence. Furthermore, the terms "include", and "have", and any variations thereof, are intended to cover non-exclusive inclusion. For example, a process, a method, a system, a product, or a device including a series of steps or units is not limited to the listed steps or units, but may optionally include steps or units that are not listed, or may optionally include other steps or units that are inherently included in the process, the method, the system, the product, or the device.

The technical solutions in the embodiments of the present disclosure will be described by referring to the accompanying drawings.

It should be noted that, for clarity, identical reference numerals denote identical components in the embodiments of the present disclosure. For brevity, detailed descriptions of identical components are omitted in various embodiments.

A wireless charging device is configured to charge an electronic device (such as a mobile phone and a tablet computer). A transmitter-side wireless charging module (TX) of the wireless charging device transmits energy with a receiver-side wireless charging module (RX) of the electronic device through respective coils, such that wireless charging is achieved. In order to ensure precise alignment between the coils of the wireless charging device and the coils of the electronic device, magnets may be arranged on both the wireless charging device and the electronic device, such that the coils of the wireless charging device may be accurately aligned with the coils of the electronic device, and the electronic device may be magnetically attached to the wireless charging device. In this way, misalignment between the coils of the wireless charging device and the coils of the electronic device may be avoided, and a charging efficiency and a charging speed of the wireless charging device may not be affected. However, magnetic flux lines generated by the magnet at the transmitter side may not fully converge onto the magnet of the receiver side, and part of the magnetic flux lines may inevitably escape. Consequently, the part of the magnetic flux lines may reach a receiver-side magnetic core (such as a nanocrystalline core) of the wireless charging module and/or a transmitter-side magnetic core of the wireless charging module, such that a bias magnetic field may be generated within the magnetic core. In this case, a magnetic flux density during practical operation may approach a saturation magnetic flux density Bs, and that is, magnetic saturation may occur easily, and the charging efficiency of the electronic device may be reduced. In addition, a magnetic pole of the receiver-side magnet facing the receiver-side wireless charging module also generates a bias magnetic field on the nanocrystalline core, such that the magnetic flux density of the nanocrystalline core during practical operation may approach a saturation magnetic flux density Bs, and that is, magnetic saturation may be caused. In this case, the inductance and the coupling effect of the transmitter-side wireless charging module and/or the receiver-side wireless charging module may be reduced, the wireless charging efficiency may be reduced, heat generated by the wireless charging device and the electronic device during wireless charging may be increased, and the charging efficiency of the electronic device may be reduced.

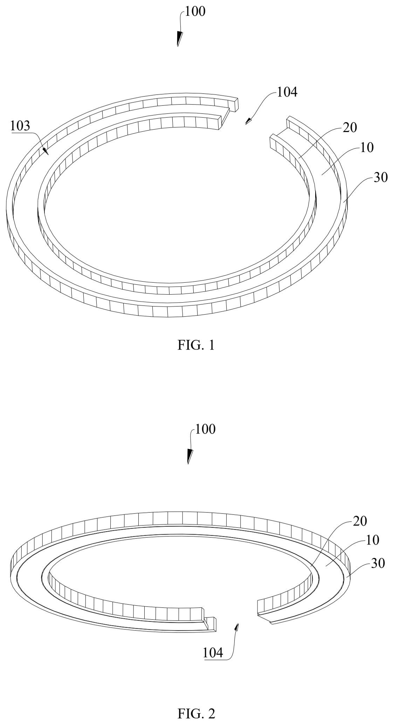

As shown in FIGS. 1 to 4, the present disclosure provides a magnetic shielding assembly 100 including a first magnetic shielding member 10, a second magnetic shielding member 20, and a third magnetic shielding member 30. The second magnetic shielding member 20 may be disposed at a side of the first magnetic shielding member 10, and a first gap 101 may be formed between the first magnetic shielding member 10 and the second magnetic shielding member 20. The third magnetic shielding member 30 may be disposed at a side of the first magnetic shielding member 10 facing away from the second magnetic shielding member 20, and a second gap 102 may be formed between the first magnetic shielding member 10 and the third magnetic shielding member 30. The first magnetic shielding member 10, the second magnetic shielding member 20, and the third magnetic shielding member 30 cooperatively define a receiving slot 103.

In some embodiments, the second magnetic shielding member 20, the first magnetic shielding member 10, and the third magnetic shielding member 30 may be arranged sequentially and may be spaced apart from each other.

In some embodiments, one or a plurality of first magnetic shielding members 10 may be arranged. When the plurality of first magnetic shielding members 10 are arranged, the plurality of first magnetic shielding members 10 may be sequentially stacked or sequentially spaced apart from each other along a direction perpendicular to a direction (i.e., a thickness direction of the magnetic shielding assembly 100) in which the second magnetic shielding member 20, the first magnetic shielding member 10, and the third magnetic shielding member 30 are arranged.

In some embodiments, one or a plurality of second magnetic shielding members 20 may be arranged. When the plurality of second magnetic shielding members 20 are arranged, the plurality of second magnetic shielding members 20 may be sequentially stacked or sequentially spaced apart from each other along a direction perpendicular to the direction in which the second magnetic shielding member 20, the first magnetic shielding member 10, and the third magnetic shielding member 30 are arranged.

In some embodiments, one or a plurality of third magnetic shielding members 30 may be arranged. When the plurality of third magnetic shielding members 30 are arranged, the plurality of third magnetic shielding members 30 may be sequentially stacked or sequentially spaced apart from each other along a direction perpendicular to the direction in which the second magnetic shielding member 20, the first magnetic shielding member 10, and the third magnetic shielding member 30 are arranged.

The magnetic shielding assembly 100 of the present disclosure may be arranged in the wireless charging device (such as a wireless charging panel) and an electronic device. The wireless charging device may include a transmitter-side wireless charging module and a magnet (hereafter referred to as a transmitter-side magnet). The transmitter-side wireless charging module may include a transmitter-side coil and a transmitter-side magnetic core. The electronic device may include a receiver-side wireless charging module and a magnet (hereafter referred to as a receiver-side magnet). The receiver-side wireless charging module may include a receiver-side coil and a receiver-side magnetic core (which may be a nanocrystalline sheet).

In some embodiments, the electronic device may be, but not limited to, a mobile phone, a tablet computer, a smartwatch, a laptop computer, a smart bracelet, an e-reader, a game console, or any other electronic device capable of being wirelessly charged.

It should be understood that the second magnetic shielding member 20 and the third magnetic shielding member 30 may protrude toward a same side with respect to the first magnetic shielding member 10, such that the first magnetic shielding member 10, the second magnetic shielding member 20, and the third magnetic shielding member 30 may cooperatively define the receiving slot 103. In other words, the first magnetic shielding member 10, the second magnetic shielding member 20, and the third magnetic shielding member 30 cooperatively form a U-shaped structure. It should be understood that the magnetic shielding assembly 100 has a U-shaped cross section when taken along a direction parallel to the direction in which the second magnetic shielding member 20, the first magnetic shielding member 10, and the third magnetic shielding member 30 are arranged.

It should be noted that the receiving slot 103 may be configured to receive a magnet (such as a permanent magnet) and configured to provide magnetic shielding for the magnet. When the magnet is placed in the receiving slot 103, both the second magnetic shielding member 20 and the third magnetic shielding member 30 may protrude beyond the magnet.

It is understood that the magnetic shielding assembly 100 may be a separatable structure where the first magnetic shielding member 10, the second magnetic shielding member 20, and the third magnetic shielding member 30 may be three independent elements.

In the present embodiment, the magnetic shielding assembly 100 may include the second magnetic shielding member 20, the first magnetic shielding member 10, and the third magnetic shielding member 30, which are sequentially arranged and are spaced apart from each other. The first magnetic shielding member 10, the second magnetic shielding member 20, and the third magnetic shielding member 30 cooperatively form the receiving slot 103 to receive the magnet. When the magnetic shielding assembly of the present disclosure is arranged in the wireless charging device to receive the transmitter-side magnet of the wireless charging device, leakage of magnetic flux lines generated by the transmitter-side magnet may be prevented, preventing any part of the magnetic flux lines generated by the transmitter-side magnet from reaching a magnetic core of the wireless charging device and the magnetic core of the electronic device. In this way, the bias magnetic field generated within the magnetic core of the transmitter-side magnetic and the magnetic core of the receiver-side magnetic may be reduced, anti-saturation performance of the magnetic core of the transmitter-side magnetic and the magnetic core of the receiver-side magnetic may be improved, the inductance and the coupling efficiency of the magnetic core of the transmitter-side magnetic and the magnetic core of the receiver-side magnetic may be improved, and therefore, the charging efficiency of the wireless charging device may be increased. Similarly, when the magnetic shielding assembly 100 of the present disclosure is arranged in electronic devices to receive the receiver-side magnet, leakage of magnetic flux lines generated by the receiver-side magnet core of may be reduced, preventing any part of the magnetic flux lines from reaching the transmitter-side magnetic core of the wireless charging device and the receiver-side magnetic core of the electronic device. The bias magnetic field generated within the transmitter-side magnetic core and the receiver-side magnetic core may be reduced, the anti-saturation performance of the transmitter-side magnetic core and the receiver-side magnetic core may be improved, the inductance and the coupling efficiency of the transmitter-side magnetic core and the receiver-side magnetic core may be improved, and therefore, the wireless charging efficiency may be increased. Furthermore, the first gap 101 may be formed between the first magnetic shielding member 10 and the second shielding isolation member 20, and the second gap 102 may be formed between the first magnetic shielding member 10 and the third magnetic shielding member 30. Compared to configurations where the first magnetic shielding member 10, the second magnetic shielding member 20, and the third magnetic shielding member 30 sequentially abut or connect to each other, the magnetic shielding assembly 100 of the present disclosure provides better magnetic shielding performance. When receiving the magnet, leakage of the magnetic flux lines generated by the magnet received in the receiving slot may be prevented optimally, the bias magnetic field generated within the transmitter-side magnetic core and the receiver-side magnetic core may be reduced better, the anti-saturation performance of the transmitter-side magnetic core and the receiver-side magnetic core may be improved better, and the inductance and the coupling efficiency of may be improved better, and the wireless charging efficiency may be increased.

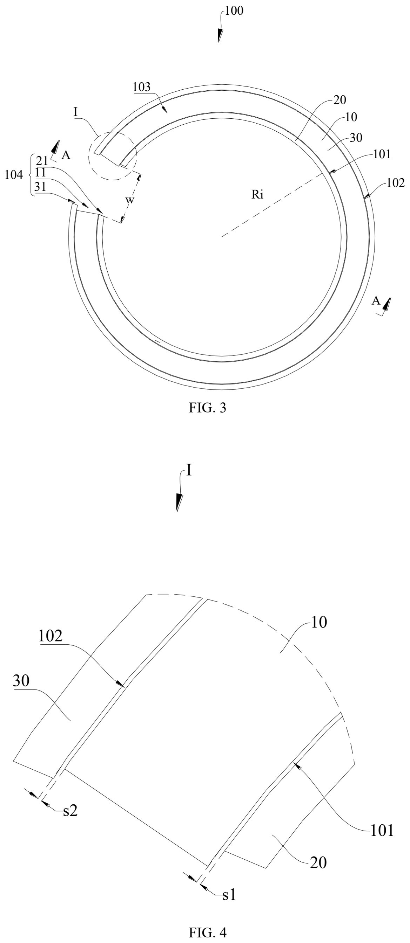

As shown in FIG. 4, in some embodiments, a width s1 of the first gap 101 may be in a range of 20 µm to 400 µm.

It is understood that a spacing between the first magnetic shielding member 10 and the second magnetic shielding member 20 may be in a range of 50 µm to 300 µm.

Specifically, the width s1 of the first gap 101 may be, but not limited to, 20µm, 30µm, 40µm, 50µm, 60µm, 80µm, 100µm, 120µm, 140µm, 160µm, 180µm, 200µm, 220 µm, 240 µm, 260 µm, 280 µm, 300 µm, 320 µm, 340 µm, 360 µm, 380 µm, 400 µm, and so on.

In the present embodiment, when the width s1 of the first gap 101 is excessively small, the magnetic shielding effect of the magnetic shielding assembly 100 may be reduced. When the magnetic shielding assembly 100 is arranged in the wireless charging devices or in the electronic device, increase in the wireless charging efficiency may not be facilitated. When the width s1 of the first gap 101 is excessively large, the magnetic shielding effect of the magnetic shielding assembly 100 may also be reduced. When the magnetic shielding assembly 100 is arranged in the wireless charging device or the electronic device, increase in the wireless charging efficiency may not be facilitated. When the width s1 of the first gap 101 is within the range of 20µm ≤ s1 ≤ 400µm, the magnetic shielding assembly 100 may provide a better magnetic shielding effect. When the magnetic shielding assembly 100 is arranged in the wireless charging device or the electronic device, the magnetic flux lines generated by the magnet may be better shielded, such that the bias magnetic field may be less likely generated on the transmitter-side magnetic core of the wireless charging device or on the receiver-side magnetic core of the electronic device. In this way, the wireless charging efficiency may be improved better.

Furthermore, the width s1 of the first gap 101 may be within the range of 50µm ≤ s1 ≤ 300µm. In this way, the magnetic shielding assembly 100 may provide a better magnetic shielding effect. When the magnetic shielding assembly 100 is arranged in the wireless charging device or the electronic device, the magnetic flux lines generated by the magnet may be better shielded, such that the bias magnetic field may not be generated on the transmitter-side magnetic core of the wireless charging device or on the receiver-side magnetic core of the electronic device. The wireless charging efficiency may be better improved.

In some embodiments, a width s2 of the second gap 102 may be in a range of 20 µm ≤ s2 ≤ 400 µm.

It should be noted that the first gap 101 may be equal to or different from the second gap 102.

In the drawings and embodiments of the present disclosure, the first gap 101 being equal to the second gap 102 may be illustrated as an example and shall not be interpreted as limiting the magnetic shielding assembly 100 of the present disclosure.

It is understood that a spacing between the first magnetic shielding member 10 and the third magnetic shielding member 30 may be in a range of 50 µm to 300 µm.

Specifically, the width s2 of the second gap 102 may be, but not limited to, 20 µm, 30 µm, 40 µm, 50 µm, 60 µm, 80 µm, 100 µm, 120 µm, 140 µm, 160 µm, 180 µm, 200 µm, 220 µm, 240 µm, 260 µm, 280 µm, 300 µm, 320 µm, 340 µm, 360 µm, 380 µm, 400 µm, and so on.

In the present embodiment, when the width s2 of the second gap 102 is excessively small, the magnetic shielding effect of the magnetic shielding assembly 100 may be reduced. When the magnetic shielding assembly 100 is arranged in the wireless charging devices or in the electronic device, increase in the wireless charging efficiency may not be facilitated. When the width s1 of the second gap 102 is excessively large, the magnetic shielding effect of the magnetic shielding assembly 100 may also be reduced. When the magnetic shielding assembly 100 is arranged in the wireless charging device or the electronic device, increase in the wireless charging efficiency may not be facilitated. When the width s1 of the second gap 102 is within the range of 20µm ≤ s2 ≤ 400µm, the magnetic shielding assembly 100 may provide a better magnetic shielding effect. When the magnetic shielding assembly 100 is arranged in the wireless charging device or the electronic device, the magnetic flux lines generated by the magnet may be better shielded, such that the bias magnetic field may be less likely generated on the transmitter-side magnetic core of the wireless charging device or on the receiver-side magnetic core of the electronic device. In this way, the wireless charging efficiency may be improved better.

Furthermore, the width s2 of the second gap 102 may be within a range of 50µm ≤ s2 ≤ 300µm. In this way, the magnetic shielding assembly 100 may provide a better magnetic shielding effect. When the magnetic shielding assembly 100 is arranged in the wireless charging device or the electronic device, the magnetic flux lines generated by the magnet may be better shielded, such that the bias magnetic field may not be generated on the transmitter-side magnetic core of the wireless charging device or on the receiver-side magnetic core of the electronic device. The wireless charging efficiency may be better improved.

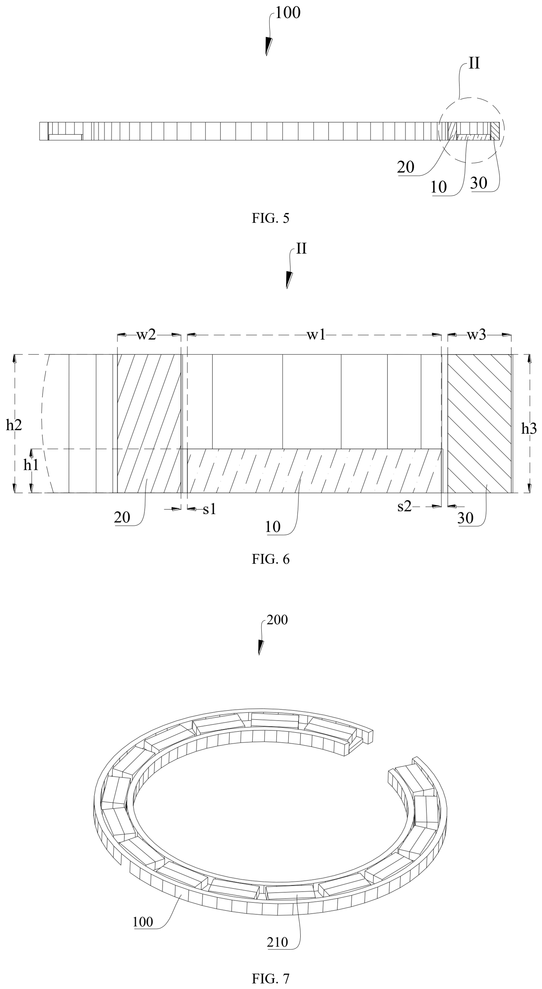

As shown in FIGS. 5 and 6, in some embodiments, along the direction in which the second magnetic shielding member 20, the first magnetic shielding member 10, and the third magnetic shielding member 30 are arranged, a width w1 of the first magnetic shielding member 10 may be within a range of 2 mm ≤ w1 ≤ 10 mm.

Specifically, along the direction in which the second magnetic shielding member 20, the first magnetic shielding member 10, and the third magnetic shielding member 30 are arranged, the width wl of the first magnetic shielding member 10 may be, but not limited to: 2 mm, 3 mm, 4 mm, 5 mm, 6 mm, 7 mm, 8 mm, 9 mm, 10 mm, and so on.

In the present embodiment, when the width w1 of the first magnetic shielding member 10 is excessively small, the magnet that can be embedded in the magnetic shielding assembly 100 may be excessively small, and a magnetic pole area may be excessively small, and a magnetic attraction force may be reduced. In addition, complexity in manufacturing the magnet may be improved. When the width w1 of the first magnetic shielding member 10 is excessively large, an overall size of the magnetic shielding assembly 100 may be excessively large, and the magnetic shielding assembly 100 may not be accommodated within the electronic device.

In some embodiments, along the thickness direction of the magnetic shielding assembly 100, a height h1 of the first magnetic shielding member 10 may be in a range of 0.05 mm ≤ h1 ≤ 2.5 mm. Here, the thickness direction of the magnetic shielding assembly 100 may intersect the direction in which the second magnetic shielding member 20, the first magnetic shielding member 10, and the third magnetic shielding member 30 are arranged.

In an embodiment, the second magnetic shielding member 20, the first magnetic shielding member 10, and the third magnetic shielding member 30 may be arranged along a radial direction of the magnetic shielding assembly 100, and the thickness direction of the magnetic shielding assembly 100 may be perpendicular to the direction in which the second magnetic shielding member 20, the first magnetic shielding member 10, and the third magnetic shielding member 30 are arranged.

It should be noted that when the magnetic shielding assembly 100 is arranged in the wireless charging device or the electronic device, the thickness direction of the magnetic shielding assembly 100 may be parallel to a thickness direction of the wireless charging device or the electronic device.

Specifically, along the thickness direction of the magnetic shielding assembly 100, the height h1 of the first magnetic shielding member 10 may be: 0.05 mm, 0.1 mm, 0.2 mm, 0.3 mm, 0.5 mm, 0.8 mm, 1.0 mm, 1.2 mm, 1.4 mm, 1.6 mm, 1.8 mm, 2.0 mm, 2.2 mm, 2.4 mm, 2.5 mm, and so on.

In the present embodiment, along the thickness direction of the magnetic shielding assembly 100, when the height h1 of the first magnetic shielding member 10 is excessively small, a magnetic induction intensity (also known as the magnetic flux density, abbreviated as magnetic flux) of the first magnetic shielding member 10 may be saturated, and the magnetic shielding effect of the first magnetic shielding member 10 may be reduced. Along the thickness direction of the magnetic shielding assembly 100, when the height h1 of the first magnetic shielding member 10 is excessively large, an overall thickness of the magnetic shielding assembly 100 may be large. When the magnetic shielding assembly 100 is arranged in the wireless charging device or in the electronic device, the thickness of the wireless charging device or the electronic device may be increased, thinness and miniaturization of the wireless charging device or the electronic device may not be achieved.

In some embodiments, along the direction in which the second magnetic shielding member 20, the first magnetic shielding member 10, and the third magnetic shielding member 30 are arranged, a width w2 of the second magnetic shielding member 20 may be in a range of 0.1 mm ≤ w2 ≤ 5 mm.

In some embodiments, the second magnetic shielding member 20, the first magnetic shielding member 10, and the third magnetic shielding member 30 may be arranged along the radial direction of the magnetic shielding assembly 100, and the width w2 of the second magnetic shielding member 20 along the radial direction of the magnetic shielding assembly 100 may be in the range of 0.1 mm ≤ w2 ≤ 5 mm.

Specifically, the width w2 of the second magnetic shielding member 20 may be, but not limited to, 0.1 mm, 0.3 mm, 0.5 mm, 1.0 mm, 1.5 mm, 2.0 mm, 2.5 mm, 3.0 mm, 3.5 mm, 4.0 mm, 4.5 mm, 5 mm, and so on.

In the present embodiment, when the width w2 of the second magnetic shielding member 20 is excessively small, a magnetic induction intensity (also known as magnetic flux density, abbreviated as magnetic flux) of the second magnetic shielding member 20 may be saturated, and the magnetic shielding effect of the second magnetic shielding member 20 may be reduced. In addition, complexity in manufacturing the second magnetic shielding member 20 may be improved. When the width w2 of the second magnetic shielding member 20 is excessively large, the overall size of the magnetic shielding assembly 100 may be excessively large (i.e., an outer diameter may be excessively large), such that the magnetic shielding assembly 100 may not be suitable for the size of the wireless charging device or the electronic device.

In some embodiments, along the thickness direction of the magnetic shielding assembly 100, the height h2 of the second magnetic shielding member 20 may be in a range of 0.2 mm ≤ h2 ≤ 5 mm, and the thickness direction of the magnetic shielding assembly 100 may intersect the direction in which the second magnetic shielding member 20, the first magnetic shielding member 10, and the third magnetic shielding member 30 are arranged.

In some embodiments, along the thickness direction of the magnetic shielding assembly 100, the height h2 of the second magnetic shielding member 20 may be greater than the height h1 of the first magnetic shielding member 10, i.e., h2 > h1.

Specifically, along the thickness direction of the magnetic shielding assembly 100, the height h2 of the second magnetic shielding member 20 may be, but not limited to, 0.2 mm, 0.3 mm, 0.5 mm, 1.0 mm, 1.5 mm, 2.0 mm, 2.5 mm, 3.0 mm, 3.5 mm, 4.0 mm, 4.5 mm, 5 mm, and so on.

In the present embodiment, when the height h2 of the second magnetic shielding member 20 is excessively small along the thickness direction of the magnetic shielding assembly 100, the second magnetic shielding member 20 may be unable to cover an upper surface of the magnet when the magnet is received in the magnetic shielding assembly 100, such that the magnetic shielding effect provided by the second magnetic shielding member 20 on the magnet may be reduced. Along the thickness direction of the magnetic shielding assembly 100, when the height h2 of the second magnetic shielding member 20 is excessively large, the overall thickness of the magnetic shielding assembly 100 may be large. When the magnetic shielding assembly 100 is arranged in the wireless charging device or in the electronic device, the thickness of the wireless charging device or the electronic device may be increased, thinness and miniaturization of the wireless charging device or the electronic device may not be achieved.

In some embodiments, along the direction in which the second magnetic shielding member 20, the first magnetic shielding member 10, and the third magnetic shielding member 30 are arranged, a width w3 of the third magnetic shielding member 30 may be in a range of 0.1 mm ≤ w3 ≤ 5 mm.

In some embodiments, the second magnetic shielding member 20, the first magnetic shielding member 10, and the third magnetic shielding member 30 may be arranged along the radial direction of the magnetic shielding assembly 100, and the width w3 of the third magnetic shielding member 30 along the radial direction of the magnetic shielding assembly 100 may be in the range of 0.1 mm ≤ w3 ≤ 5 mm.

Specifically, the width w3 of the third magnetic shielding member 30 may be, but not limited to, 0.1 mm, 0.3 mm, 0.5 mm, 1.0 mm, 1.5 mm, 2.0 mm, 2.5 mm, 3.0 mm, 3.5 mm, 4.0 mm, 4.5 mm, 5 mm, and so on.

In the present embodiment, when the width w3 of the third magnetic shielding member 30 is excessively small, a magnetic induction intensity (also known as magnetic flux density, abbreviated as magnetic flux) of the third magnetic shielding member 30 may be saturated, and the magnetic shielding effect of the third magnetic shielding member 30 may be reduced. In addition, complexity in manufacturing the third magnetic shielding member 30 may be improved. When the width w3 of the third magnetic shielding member 30 is excessively large, the overall size of the magnetic shielding assembly 100 may be excessively large (i.e., the outer diameter may be excessively large), such that the magnetic shielding assembly 100 may not be suitable for the size of the wireless charging device or the electronic device.

In some embodiments, along the thickness direction of the magnetic shielding assembly 100, a height h3 of the third magnetic shielding member 30 may be in a range of 0.2 mm ≤ h3 ≤ 5 mm, and the thickness direction of the magnetic shielding assembly 100 may intersect the direction in which the second magnetic shielding member 20, the first magnetic shielding member 10, and the third magnetic shielding member 30 are arranged.

In some embodiments, along the thickness direction of the magnetic shielding assembly 100, the height h3 of the third magnetic shielding member 30 may be greater than the height h1 of the first magnetic shielding member 10, i.e., h3 > h1.

Specifically, along the thickness direction of the magnetic shielding assembly 100, the height h3 of the third magnetic shielding member 30 may be, but not limited to, 0.2 mm, 0.3 mm, 0.5 mm, 1.0 mm, 1.5 mm, 2.0 mm, 2.5 mm, 3.0 mm, 3.5 mm, 4.0 mm, 4.5 mm, 5 mm, and so on.

In the present embodiment, when the height h3 of the third magnetic shielding member 30 is excessively small along the thickness direction of the magnetic shielding assembly 100, the third magnetic shielding member 30 may be unable to cover the upper surface of the magnet when the magnet is received in the magnetic shielding assembly 100, such that the magnetic shielding effect provided by the third magnetic shielding member 30 on the magnet may be reduced. Along the thickness direction of the magnetic shielding assembly 100, when the height h3 of the third magnetic shielding member 30 is excessively large, the overall thickness of the magnetic shielding assembly 100 may be large. When the magnetic shielding assembly 100 is arranged in the wireless charging device or in the electronic device, the thickness of the wireless charging device or the electronic device may be increased, thinness and miniaturization of the wireless charging device or the electronic device may not be achieved.

As shown in FIGS. 1 to 3, in some embodiments, each of the first magnetic shielding member 10, the second magnetic shielding member 20, and the third magnetic shielding member 30 may be an annular element. The first magnetic shielding member 10 may surround an outer periphery of the second magnetic shielding member 20, and the third magnetic shielding member 30 may surround an outer periphery of the first magnetic shielding member 10. The magnetic shielding assembly 100 has a gap 104 at which the second magnetic shielding member 20 may be discontinuous, the first magnetic shielding member 10 may be discontinuous, and the third magnetic shielding member 30 may be discontinuous.

It should be understood that the second magnetic shielding member 20, the first magnetic shielding member 10, and the third magnetic shielding member 30 may be arranged sequentially from an innermost to an outermost along the radial direction of the magnetic shielding assembly 100.

In some embodiments, the annular element may be, but not limited to, at least one of: a circular ring, an elliptical ring, a quasi-circular ring, a quasi-elliptical ring, a rectangular ring, or a quasi-rectangular ring.

It is understood that in the present embodiment, the receiving slot 103 may be an annular slot.

In some embodiments, the first magnetic shielding member 10 may have a first sub-notch 11, the second magnetic shielding member 20 may have a second sub-notch 21, and the third magnetic shielding member 30 may have a third sub-notch 31. The first sub-notch 11, the second sub-notch 21, and the third sub-notch 31 cooperatively form the notch 104. It should be understood that the second sub-notch 21, the first sub-notch 11, and the third sub-notch 31 may be arranged corresponding to and sequentially communicated to each other.

In the present embodiment, the gap 104 may interrupt each of the first magnetic shielding member 10, the second magnetic shielding member 20, and the third magnetic shielding member 30. In this way, large eddy currents may be prevented from being formed on the first magnetic shielding member 10, the second magnetic shielding member 20, and the third magnetic shielding member 30, and losses in the magnetic shielding assembly 100 may be reduced. Therefore, when the magnetic shielding assembly 100 is arranged in the wireless charging device or the electronic device, the wireless charging efficiency may not be reduced.

As shown in FIG. 3, in some embodiments, the width w of the gap 104 along a circumference of the magnetic shielding assembly 100 may be in a range of 0.1 mm ≤ w ≤ 50 mm.

It is understood that, along a direction perpendicular to the radial direction of the magnetic shielding assembly 100, the width w of the gap 104 may be in a range of 0.1 mm ≤ w ≤ 50 mm.

It should be noted that the width w of the gap 104 may be uniform or non-uniform along the circumference of the magnetic shielding assembly 100. For example, when the first magnetic shielding member 10, the second magnetic shielding member 20, and the third magnetic shielding member 30 are rectangular rings, the width w of the gap 104 may be uniform. In another example, when the first magnetic shielding member 10, the second magnetic shielding member 20, and the third magnetic shielding member 30 are circular rings, the width of the gap 104 may be non-uniform. The width of the gap 104 may gradually increase along a direction extending from the second magnetic shielding member 20 toward the third magnetic shielding member 30, and that is, the width of the gap 104 may gradually increase, along the radial direction of the magnetic shielding assembly 100 extending from a center of the magnetic shielding assembly 100 outwardly.

Specifically, along the circumference of the magnetic shielding assembly 100, the width w of the notch 104 may be, but not limited to: 0.1 mm, 0.5 mm, 1 mm, 3 mm, 5 mm, 8 mm, 10 mm, 15 mm, 20 mm, 25 mm, 30 mm, 35 mm, 40 mm, 45 mm, 50 mm, and so on.

In the present embodiment, when the width w of the notch 104 is excessively small, complexity in manufacturing the first magnetic shielding member 10, the second magnetic shielding member 20, and the third magnetic shielding member 30 may be increased. When the width w of the notch 104 is excessively large, a large amount of materials may need to be removed from the first magnetic shielding member 10, the second magnetic shielding member 20, and the third magnetic shielding member 30. The size of the magnet that may be embedded within the receiving slot 103 of the magnetic shielding assembly 100 may be reduced, and the magnetic attraction force of the magnet may be reduced. When the magnetic shielding assembly 100 is arranged in the wireless charging device or in the electronic device, alignment between the wireless charging device and the electronic device may not be achieved properly.

In some embodiments, each of the first magnetic shielding member 10, the second magnetic shielding member 20, and the third magnetic shielding member 30 may be the annular element, and an inner diameter Ri of the second magnetic shielding member 20 may be in a range of 15 mm ≤ Ri ≤ 30 mm.

It is understood that an inner diameter of the magnetic shielding assembly 100 may be in a range of 15 mm to 30 mm.

It should be understood that in the present embodiment, the receiving slot 103 may be a circular ring-shaped receiving slot 103.

Specifically, the inner diameter Ri of the second magnetic shielding member 20 may be, but not limited to, 15 mm, 16 mm, 18 mm, 20 mm, 22 mm, 24 mm, 26 mm, 28 mm, 30 mm, and so on.

In the present embodiment, when the inner diameter Ri of the second magnetic shielding member 20 is excessively small, and when the magnetic shielding assembly 100 is arranged in the wireless charging device, the size of the transmitter-side magnetic core (transmitter-side ferrite) of the wireless charging device may be compressed. In this case, a magnetic resistance of the transmitter-side magnetic core may be increased, and an inductance of the transmitter-side magnetic core may be reduced, and the wireless charging efficiency may be reduced. When the inner diameter Ri of the second magnetic shielding member 20 is excessively large, the outer diameter of the entire magnetic shielding assembly 100 may be excessively large, and the entire magnetic shielding assembly 100 may not be suitable with the size of the wireless charging device or the electronic device.

In some embodiments, the first magnetic shielding member 10 may be, but not limited to, an iron-based alloy.

In some embodiments, the second magnetic shielding member 20 may be, but not limited to, an iron-based alloy.

In some embodiments, the third magnetic shielding member 30 may be, but not limited to, an iron-based alloy.

In some embodiments, the iron-based alloy may include, but not limited to, at least one of: FeSi alloy, FeSiAl alloy, FeCo alloy, FeNi alloy, FeNiMo alloy, and 400-series ferritic stainless steel.

In some embodiments, a material of the first magnetic shielding member 10 may include at least one of FeSi alloy, FeSiAl alloy, FeCo alloy, FeNi alloy, FeNiMo alloy, or 400-series ferritic stainless steel. The first magnetic shielding member 10 prepared using the above material may provide better magnetic shielding performance. When the magnetic shielding assembly 100 is arranged in the wireless charging device or in the electronic device, the better magnetic shielding performance may be provided for the magnet, and the wireless charging efficiency may be improved better.

In some embodiments, a material of the second magnetic shielding member 20 may include at least one of FeSi alloy, FeSiAl alloy, FeCo alloy, FeNi alloy, FeNiMo alloy, or 400-series ferritic stainless steel. The second magnetic shielding member 20 prepared using the above material may provide better magnetic shielding performance. When the magnetic shielding assembly 100 is arranged in the wireless charging device or in the electronic device, the better magnetic shielding performance may be provided for the magnet, and the wireless charging efficiency may be improved better.

**In** some embodiments, a material of the third magnetic shielding member 30 may include at least one of FeSi alloy, FeSiAl alloy, FeCo alloy, FeNi alloy, FeNiMo alloy, or 400-series ferritic stainless steel. The third magnetic shielding member 30 prepared using the above material may provide better magnetic shielding performance. When the magnetic shielding assembly 100 is arranged in the wireless charging device or in the electronic device, the better magnetic shielding performance may be provided for the magnet, and the wireless charging efficiency may be improved better.

In some embodiments, the first magnetic shielding member 10, the second magnetic shielding member 20, and the third magnetic shielding member 30 may be made of the same material or different materials.

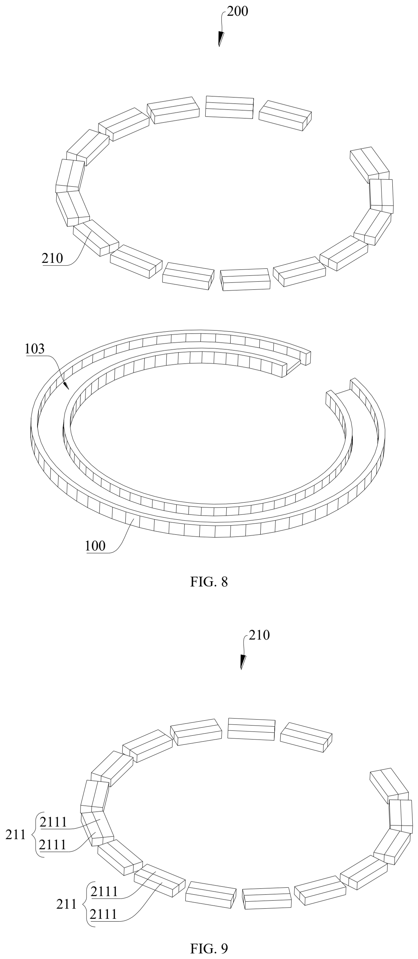

As shown in FIGS. 7 and 8, the present disclosure further provides a magnetic attraction assembly 200, including the magnetic shielding assembly 100 described in the present disclosure and a magnet 210. The magnet 210 may be received in the receiving slot 103 of the magnetic shielding assembly 100.

In some embodiments, the magnet 210 may be, but not limited to, a permanent magnet.

In some embodiments, the permanent magnet may be, but not limited to, an iron magnet.

The magnetic shielding assembly 100 of the present disclosure may be arranged in the wireless charging device or in the electronic device having a wireless charging function.

In some embodiments, the magnet 210 may be an integral and one-piece structure or a separatable structure.

As shown in FIG. 9, in some embodiments, the magnet 210 may include a plurality of sub-magnet assemblies 211, and the plurality of sub-magnet assemblies 211 may be spaced apart from each other and distributed along an extension direction of the receiving slot 103. Understandably, the plurality of sub-magnet assemblies 211 may be supported on the first magnetic shielding member 10, and the plurality of sub-magnet assemblies 211 may be spaced apart from each other and surround the outer periphery of the second magnetic shielding member 20.

In some embodiments, each of the plurality of sub-magnet assemblies 211 may include two sub-magnets 2111 that are arranged along the radial direction of the magnetic shielding assembly 100, and the two sub-magnets 210 may abut against each other.

The magnetic attraction assembly 200 of the present disclosure may include the magnetic shielding assembly 100 and the magnet 210. The magnet 210 may be received in the receiving slot 103 of the magnetic shielding assembly 100. The magnetic shielding assembly 100 may include the first magnetic shielding member 10, the second magnetic shielding member 20, and the third magnetic shielding member 30 that are arranged sequentially and are spaced apart from each other. The magnetic shielding assembly 100 may prevent the leakage of the magnetic flux lines generated by the magnet 210. When the magnetic attraction assembly 200 is arranged in the wireless charging device or in the electronic device, the magnetic flux lines generated by the magnet 210 may be prevented from reaching the transmitter-side magnetic core of the wireless charging device or reaching the receiver-side magnetic core of the electronic device. The bias magnetic field generated in the transmitter-side magnetic core and the receiver-side magnetic core may be reduced, the anti-saturation performance of the transmitter-side magnetic core and the receiver-side magnetic core may be improved, the inductance and the coupling efficiency of the transmitter-side magnetic core and the receiver-side magnetic core may be improved, and the charging efficiency of the wireless charging device may be increased.

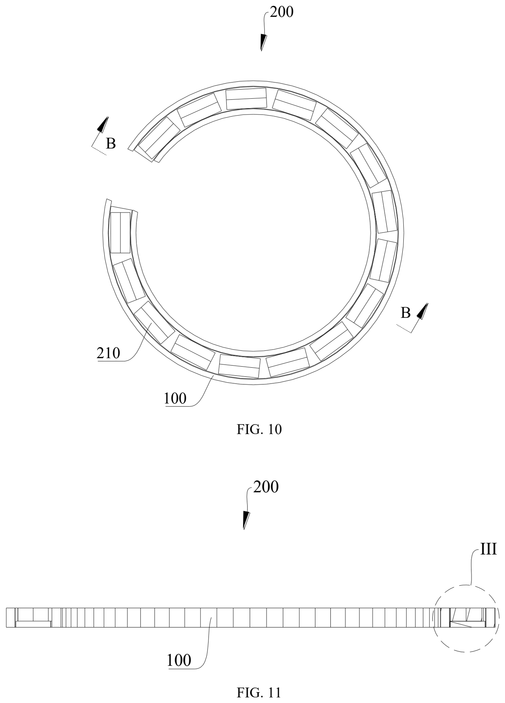

As shown in FIGS. 10 to 12, in some embodiments, along the direction in which the second magnetic shielding member 20, the first magnetic shielding member 10, and the third magnetic shielding member 30 are arranged, the width wl of the first magnetic shielding member 10 may be greater than the width w4 of the magnet 210.

In the present embodiment, the width w1 of the first magnetic shielding member 10 may be greater than the width w4 of the magnet 210. In this way, mounting the magnet 210 may be facilitated, the magnetic flux lines of the magnet 210 may be shielded better, and the better magnetic shielding may be provided for the magnet 210. When the magnetic assembly 200 is arranged in the wireless charging device or in the electronic device, the bias magnetic field generated by the magnet 210 in both the transmitter-side magnetic core and receiver-side magnetic core may be reduced more effectively. The anti-saturation performance of the transmitter-side magnetic core and receiver-side magnetic core may be improved, the inductance and the coupling efficiency of the transmitter-side magnetic core and receiver-side magnetic core may be improved, and the charging efficiency of the wireless charging device may be increased.

In some embodiments, one or a plurality of magnets 210 may be arranged. When the plurality of magnets 210 are arranged, the plurality of magnets 210 may be spaced apart from each other and may be distributed along the extension direction of the receiving slot 103.

In some embodiments, along the direction in which the second magnetic shielding member 20, the first magnetic shielding member 10, and the third magnetic shielding member 30 are arranged, a difference wl-w4 between the width w1 of the first magnetic shielding member 10 and the width w4 of the magnet 210 may be in a range of 0.1 mm ≤ wl-w4 ≤ 2 mm.

Specifically, the difference w1-w4 between the width w1 of the first magnetic shielding member 10 and the width w4 of the magnet 210 may be, but not limited to, 0.1 mm, 0.2 mm, 0.4 mm, 0.6 mm, 0.8 mm, 1.0 mm, 1.2 mm, 1.4 mm, 1.6 mm, 1.8 mm, 2 mm, and so on.

In the present embodiment, when the difference wl-w4 between the width w1 of the first magnetic shielding member 10 and the width w4 of the magnet 210 is excessively small, the magnetic shielding effect provided by the first magnetic shielding member 10 on the magnet 210 may be reduced. When the difference wl-w4 between the width w1 of the first magnetic shielding member 10 and the width w4 of the magnet 210 is excessively large, the size of the magnet 210 may be excessively small, and the magnetic attraction force thereof may be reduced. When the magnetic shielding assembly is arranged in the wireless charging device or in the electronic device, alignment between the wireless charging device and the electronic device may not be achieved properly.

In some embodiments, a surface of the first magnetic shielding member 10 facing away from the receiving slot 103 may flush with an end of the second magnetic shielding member 20 and an end of the third magnetic shielding member 30. Along the thickness direction of the magnetic shielding assembly 100, the height of the first magnetic shielding member 10 may be h1, and the height of the second magnetic shielding member 20 may be h2, the height of the third magnetic shielding member 30 may be h3, and the height of the magnet 210 may be h4. The magnetic attraction assembly 200 may satisfy: h2 ≥ h1 + h4, h3 ≥ h1 + h4.

In the present embodiment, h2 ≥ h1 + h4 and h3 ≥ h1 + h4, and in this way, the magnetic flux lines of the magnet 210 may be more effectively blocked, and the better magnetic shielding effect may be provided for the magnet 210. When the magnet 210 is arranged in the wireless charging device or in the electronic device, the bias magnetic field generated by the magnet 210 in the transmitter-side magnetic core and in the receiver-side magnetic core may be more significantly reduced. The anti-saturation performance of the transmitter-side magnetic core and the receiver-side magnetic core may be improved, the inductance and the coupling efficiency of the transmitter-side magnetic core and in the receiver-side magnetic core may be improved, and the charging efficiency of the wireless charging device may be increased.

In some embodiments, 0.1 mm ≤ h2 - (h1 + h4) ≤ 1 mm. Specifically, h2- (h1 + h4) may be, but not limited to, 0.1 mm, 0.2 mm, 0.3 mm, 0.4 mm, 0.5 mm, 0.6 mm, 0.7 mm, 0.8 mm, 0.9 mm, 1.0 mm, and so on. When h2-(h1+h4) is excessively small, the magnetic shielding effect provided by the second magnetic shielding member 20 on the magnet 210 may be reduced. When the second magnetic shielding member 20 is arranged in the wireless charging device or in the electronic device, the magnetic flux lines generated by the magnet 210 may still cause both the transmitter-side magnetic core and the receiver-side magnetic core to generate the large bias magnetic field, the wireless charging efficiency may not be improved. When h2-(h1+h4) is excessively large, the overall thickness of magnetic attraction assembly 200 may be large. When the magnetic attraction assembly 200 is arranged in the wireless charging device or in the electronic device, the thickness of the wireless charging device or the electronic device may be improved, and thinness and miniaturization of the wireless charging device or the electronic device may be affected.

In some embodiments, 0.1 mm ≤ h3 - (h1 + h4) ≤ 1 mm. Specifically, h3 - (h1 + h4) may be, but not limited to, 0.1 mm, 0.2 mm, 0.3 mm, 0.4 mm, 0.5 mm, 0.6 mm, 0.7 mm, 0.8 mm, 0.9 mm, 1.0 mm, and so on. When h3-(h1+h4) is excessively small, the magnetic shielding effect provided by the third magnetic shielding member 30 on the magnet 210 may be reduced. When the third magnetic shielding member 30 is arranged in the wireless charging device or in the electronic device, the magnetic flux lines generated by the magnet 210 may still cause both the transmitter-side magnetic core and the receiver-side magnetic core to generate the large bias magnetic field, the wireless charging efficiency may not be improved. When h3-(h1+h4) is excessively large, the overall thickness of the magnetic attraction assembly 200 may be large. When the magnetic attraction assembly 200 is arranged in the wireless charging device or in the electronic device, the thickness of the wireless charging device or the electronic device may be improved, and thinness and miniaturization of the wireless charging device or the electronic device may be affected.

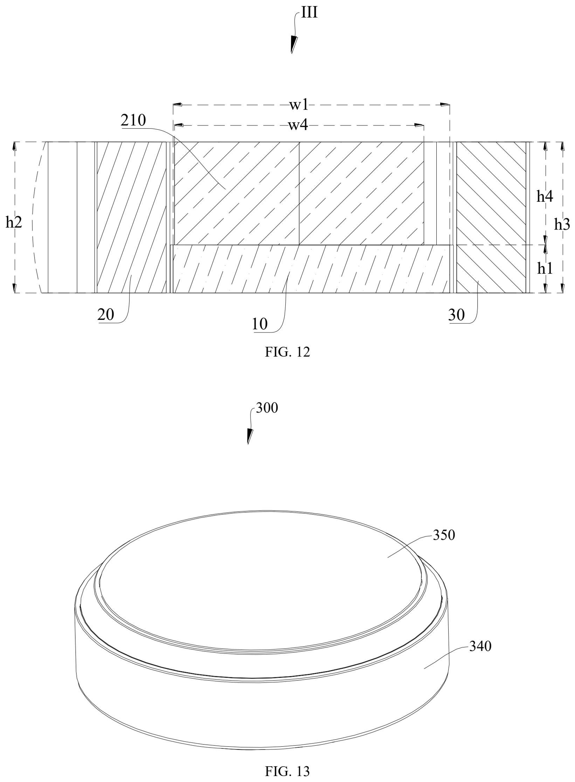

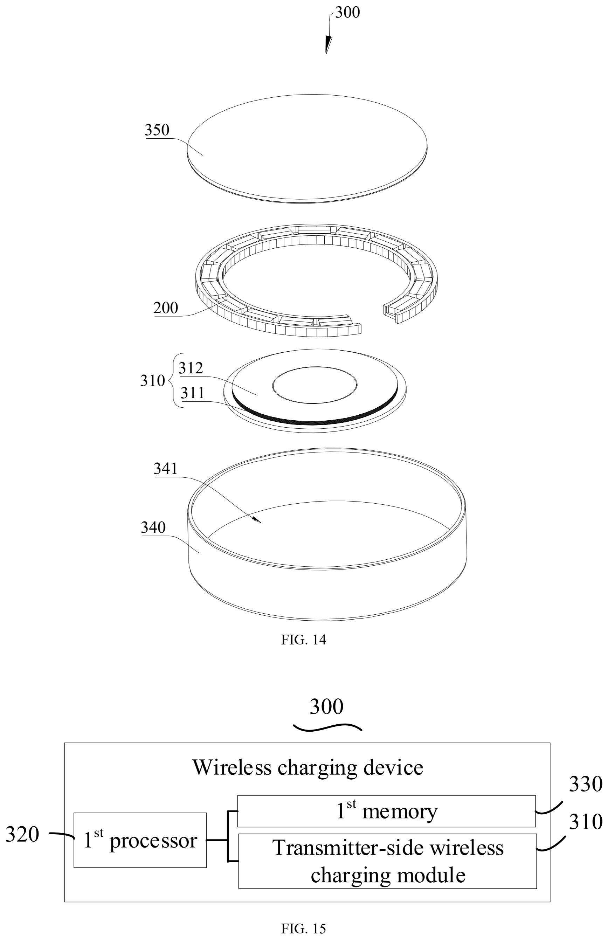

As shown in FIGS. 13 and 14, the present disclosure further provides a wireless charging device 300, including a transmitter-side wireless charging module 310 and the magnetic attraction assembly 200 described in the present disclosure. The magnetic attraction assembly 200 may surround an outer periphery of the transmitter-side wireless charging module 310.

In some embodiments, the transmitter-side wireless charging module 310 may include a transmitter-side coil 311 and a transmitter-side magnetic core 312. The transmitter-side coil 311 may sleeve around a portion of the outer periphery of the transmitter-side magnetic core 312.

The wireless charging device 300 of the present disclosure may be configured to wirelessly charge portable electronic devices, such as the mobile phone, the tablet computer, the smartwatch, the laptop, the smart bracelet, the e-reader, and the game console. When the wireless charging device 300 is used to charge the electronic device, the electronic device may be placed on a surface of the wireless charging device 300 (i.e., the electronic device is attached to the wireless charging device 300). The magnetic attraction assembly 200 may be configured to magnetically attach the electronic device to the wireless charging device 300 and to enable the transmitter-side coil 311 to be disposed corresponding to the receiver-side coil of the electronic device. It should be noted that when the wireless charging device 300 is charging the electronic device, an opening of the receiving slot 103 of the magnetic attraction assembly 200 may face the electronic device. In other words, the magnet 210 may be disposed between the first magnetic shielding member 10 and the electronic device.

In some embodiments, the wireless charging device 300 may be, but not limited to, a plate-shaped structure. In some embodiments, the plate-shaped structure may be, but not limited to, circular, elliptical, rectangular, or rectangular-like shaped. In some embodiments, an extension plane of the wireless charging device 300 may be perpendicular to the thickness direction of the wireless charging device 300.

It should be noted that, during charging, the wireless charging device 300 is configured to electrically connect to an external power source to load electrical signals and transmit energy to charge the electronic device.

In some embodiments, the wireless charging device 300 may further include a housing 340 and a cover plate 350. The housing 340 and the cover plate 350 cooperatively define a mounting space 341. The mounting space 341 is configured to receive the magnetic attraction assembly 200 and the transmitter-side wireless charging module 310.

As shown in FIG. 15, In some embodiments, the wireless charging device 300 further includes a first processor 320 and a first memory 330. The first processor 320 may be electrically connected to the first memory 330 and the transmitter-side coil 311. The first processor 320 may be configured to control the receiver-side wireless charging module to achieve charging. The first memory 330 may be configured to store program codes required for the first processor 320 to operate.

In some embodiments, the first processor 320 may include one or more general-purpose processors. The general-purpose processor may be any type of device capable of processing electronic instructions and may include a central processing unit (CPU), a microprocessor, a microcontroller, a main processor, a controller, an ASIC, and the like. The first processor 320 may execute various types of digital storage instructions, such as software or firmware programs stored in the first memory 330, enabling a computing device to provide a wide range of services.

In some embodiments, the first memory 330 may include a volatile memory, such as a random access memory (RAM). The first memory 330 may also include a non-volatile memory (NVM), such as a read-only memory (ROM), a flash memory (FM), a hard disk drive (HDD), or a solid-state drive (SSD). The first memory 330 may further include combination of the aforementioned types of memories.

It should be understood that the wireless charging device 300 described in the present disclosure represents merely one form of wireless charging device 300 in which the magnetic shielding assembly 100 may be arranged and does not limit the scope of the wireless charging device 300 provided by the present disclosure, nor limit the scope of the magnetic shielding assembly 100 provided by various embodiments of the present disclosure.

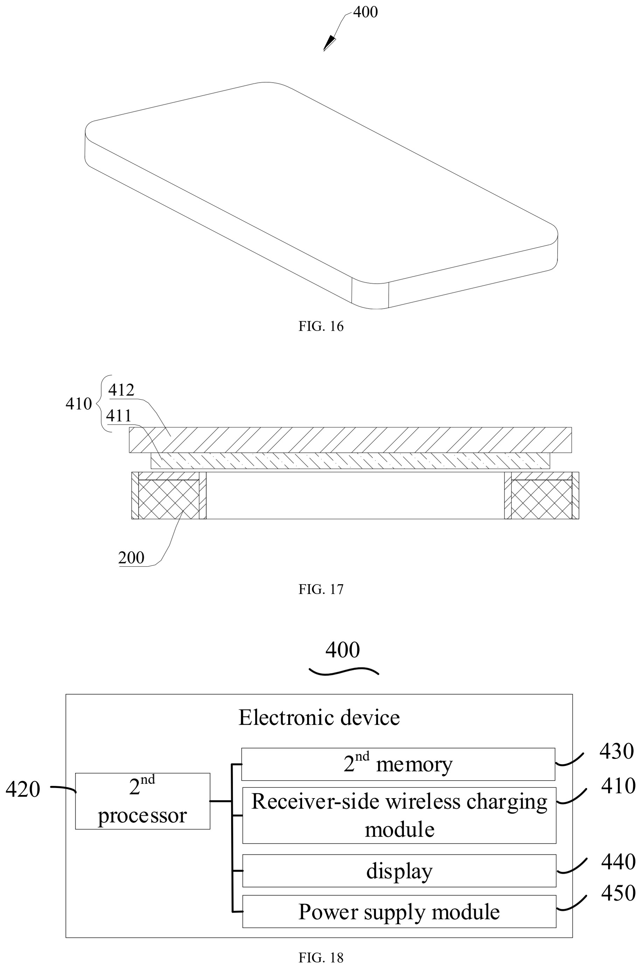

As shown in FIGS. 16 and 17, the present disclosure further provides an electronic device 400, including: a receiver-side wireless charging module 410 and the magnetic attraction assembly 200 described in the present disclosure. The magnetic attraction assembly 200 may surround an outer periphery of the receiver-side wireless charging module 410.

In some embodiments, the receiver-side wireless charging module 410 may include a receiver-side coil 411 and a receiver-side magnetic core 412. The receiver-side coil 411 and the receiver-side magnetic core 412 may be stacked along the thickness direction of the electronic device 400. The receiver-side coil 411 may be disposed between the magnetic attraction assembly 200 and the receiver-side magnetic core 412, and the opening of the receiving coil 103 of the magnetic attraction assembly 200 may face away from the receiver-side coil 411.

The electronic device 400 of the present disclosure may be, but not limited to, a portable electronic device 400 such as a mobile phone, a tablet computer, a smartwatch, a laptop computer, a smart bracelet, an e-reader, or a game console.

As shown in FIG. 18, in some embodiments, the electronic device 400 further includes a second processor 420, a second memory 430, a display 440, and a power supply module 450. The second processor 420 may be electrically connected to the second memory 430, the display 440, the power supply module 450, and the receiver-side wireless charging module 410. The power supply module 450 may further be electrically connected to the receiver-side wireless charging module 410. The second processor 420 may control the display 440 to display information and control the receiver-side wireless charging module 410 to receive energy transmitted from the transmitter-side wireless charging module 310 of the wireless charging device 300 to charge the power supply module 450.

In some embodiments, the second processor 420 may include one or more general-purpose processors. The general-purpose processor may be any type of device capable of processing electronic instructions and may include a central processing unit (CPU), a microprocessor, a microcontroller, a main processor, a controller, and an ASIC, and so on. The second processor 420 may execute various types of digital stored instructions, such as software or firmware programs stored in the second memory 430, to enable the computing device to provide a broad range of services.

In some embodiments, the second memory 430 may include a volatile memory, such as a random access memory (RAM). The secondary memory 430 may further include a non-volatile memory (NVM), such as a read-only memory (ROM), a flash memory (FM), a hard disk drive (HDD), or a solid-state drive (SSD). The secondary memory 430 may include a combination of the aforementioned types of memories.

In some embodiments, the display 440 may be, but not limited to, one or more of: a liquid crystal display (LCD), a light-emitting diode (LED) display, a micro light-emitting diode (Micro LED) display, a sub-millimeter light-emitting diode (Mini LED) display, or an organic light-emitting diode (OLED) display.

In some embodiments, the power supply module 450 may be, but not limited to, a battery, a battery module, and so on.

It should be understood that the electronic device 400 described in the above embodiments may represent merely one form of electronic devices 400 in which the magnetic shielding assembly 100 may be arranged. The above description does not limit the scope of the electronic device 400 provided in the present disclosure, and does not limit the scope of the magnetic shielding assembly 100 provided by the various embodiments of the present disclosure.

The following specific embodiments provide further description of the magnetic shielding assembly 100 of the present disclosure.

### Embodiments 1 to 7

The wireless charging device 300 in each embodiment may include the transmitter-side wireless charging module 310 and the magnetic attraction assembly 200. The transmitter-side wireless charging module 310 may include the transmitter-side coil 311 and the transmitter-side magnetic core 312. The transmitter-side magnetic core 312 may include a first cylinder and a second cylinder connected to the first cylinder. The first cylinder and the second cylinder may cooperatively form a T-shaped structure. The first cylinder may have a diameter of 45 mm and a height of 1.2 mm. The second cylinder may have a diameter of 22 mm and a height of 1.0 mm. The transmitter-side magnetic core 312 may be made of a ferrite material. The transmitter-side coil 311 may surround an outer periphery of the second cylinder. The transmitter-side coil 311 may have an inner diameter of 24 mm, an outer diameter of 45 mm, and 10 coil turns. The magnetic attraction assembly 200 of the wireless charging device 300 may include the magnetic shielding assembly 100 and the magnet 210. The magnetic shielding assembly 100 may be an annular structure and may include the first magnetic shielding member 10, the second magnetic shielding member 20, and the third magnetic shielding member 30. The width w1 of the first magnetic shielding member 10 may be 4 mm, and the height h1 of the first magnetic shielding member 10 may be 2 mm. The inner diameter Ri of the second magnetic shielding element 20 may be 45 mm, the width w2 of the second magnetic shielding element 20 may be 1 mm, and the height h2 of the second magnetic shielding element 20 may be 2.2 mm. The width w3 of the third magnetic shielding member 30 may be 1 mm, and the height h3 of the third magnetic shielding member 30 may be 2.2 mm. For the magnetic shielding assembly 100 of the wireless charging device 300 in each embodiment, the width s1 of the first gap 101 may be equal to the width s2 of the second gap 102. A maximum dimension of the notch 104 in the magnetic shielding assembly 100 may be 10 mm. The magnet 210 may include 16 sub-magnet assemblies 211. The 16 sub-magnet assemblies 211 may be uniformly arranged along the extension direction of the receiving slot 103. Each of the 16 sub-magnet assemblies 211 may include two sub-magnets 2111 that are arranged along the radial direction of the magnetic attraction assembly 200. Each sub-magnet 2111 may be a rectangular prism, having a length of 7.5 mm, a width of 1.8 mm, and a thickness of 1.5 mm.

In each embodiment, the electronic device 400 may include a receiver-side wireless charging module 410 and the magnetic attraction assembly 200. The receiver-side wireless charging module 410 may include a receiver-side coil 411 and a receiver-side magnetic core 412 stacked on the receiver-side coil 411. The receiver-side magnetic core 412 may be a square structure in a size of 60 mm × 60 mm, having a thickness of 50 µm. The receiver-side magnetic core 412 may be made of nanocrystalline steel. The receiver-side coil 411 may have an inner diameter of 22 mm, an outer diameter of 45 mm, and 8 coil turns. The magnetic attraction assembly 200 of the electronic device 400 may include the first magnetic shielding member 10 and the magnet 210. The first magnetic shielding member 10 may be an annular structure having a width w1 of 4 mm and a height h1 of 2 mm. A maximum dimension of the first sub-notch 11 in the first magnetic shielding member 10 may be 10 mm. The magnet 210 may include 16 sub-magnet assemblies 211. The 16 sub-magnet assemblies 211 may be uniformly distributed along the extension direction of the receiving slot 103. Each sub-magnet assembly 211 may include two sub-magnets 2111 that are arranged along the radial direction of the magnetic attraction assembly 200. The sub-magnet 2111 may be a rectangular prism structure having a length of 7.5 mm, a width of 1.8 mm, and a thickness of 1.5 mm. That is, a difference between the magnetic attraction assembly 200 of the electronic device 400 and the magnetic attraction assembly 200 of the wireless charging device 300 is that the electronic device 400 does not include the second magnetic shielding member 20 and the third magnetic shielding member 30. For the wireless charging device 300 in each embodiment in each embodiment, the width s1 of the first gap 101 and the width s2 of the second gap 102 in the magnetic shielding assembly 100 of the magnetic attraction assembly 200 may be shown in Table 1 below.

### Control Embodiment 1

A difference between the Control Embodiment 1 and the Embodiment 1 is that the magnetic shielding assembly 100 of the Control Embodiment 1 may include only the first magnetic shielding member 10 and does not include the second magnetic shielding member 20 or the third magnetic shielding member 30.

### Control Embodiment 2

A difference between the Control Embodiment 2 and the Embodiment 1 is that the first gap 101 and the second gap 102 of the magnetic shielding assembly 100 in the Control Embodiment 2 are both 0, and the first magnetic shielding member 10, the second magnetic shielding member 20, and the third magnetic shielding member 30 are integrally formed as a one-piece structure.

According to SJ/T 10298-1991, a self-inductance Lp of the transmitter-side wireless charging module 310, the self-inductance Ls of the receiver-side wireless charging module 410, a mutual inductance M between the transmitter-side wireless charging module 310 and the receiver-side wireless charging module 410, and the bias magnetic field generated by the receiver-side magnetic core 412 are measured.

Test results for each embodiment and the control embodiment are shown in Table 1 below.

| Embodiments | s1 and s2 of the wireless charging device | Ls(µH) | M(µH) | Lp(µH) | M/Lp | bias magnetic field generated by the receiver-side magnetic core (T) |
|---|---|---|---|---|---|---|
| Embodiment 1 | 20µm | 7.32 | 9.85 | 19.85 | 0.4962 | 0.786 |
| Embodiment 2 | 50µm | 7.57 | 10.27 | 20.54 | 0.5000 | 0.777 |
| Embodiment 3 | 80µm | 7.75 | 10.57 | 21.04 | 0.5024 | 0.772 |
| Embodiment 4 | 100µm | 7.78 | 10.62 | 21.12 | 0.5028 | 0.769 |
| Embodiment 5 | 200µm | 7.82 | 10.78 | 21.47 | 0.5021 | 0.773 |
| Embodiment 6 | 300µm | 7.84 | 10.86 | 21.64 | 0.5018 | 0.780 |
| Embodiment 7 | 400µm | 7.93 | 11.02 | 21.93 | 0.5025 | 0.788 |
| Control Embodiment 1 | / | 4.09 | 5.48 | 13.39 | 0.4093 | 0.971 |
| Control Embodiment 2 | 0 | 7.14 | 9.51 | 19.21 | 0.4951 | 0.793 |

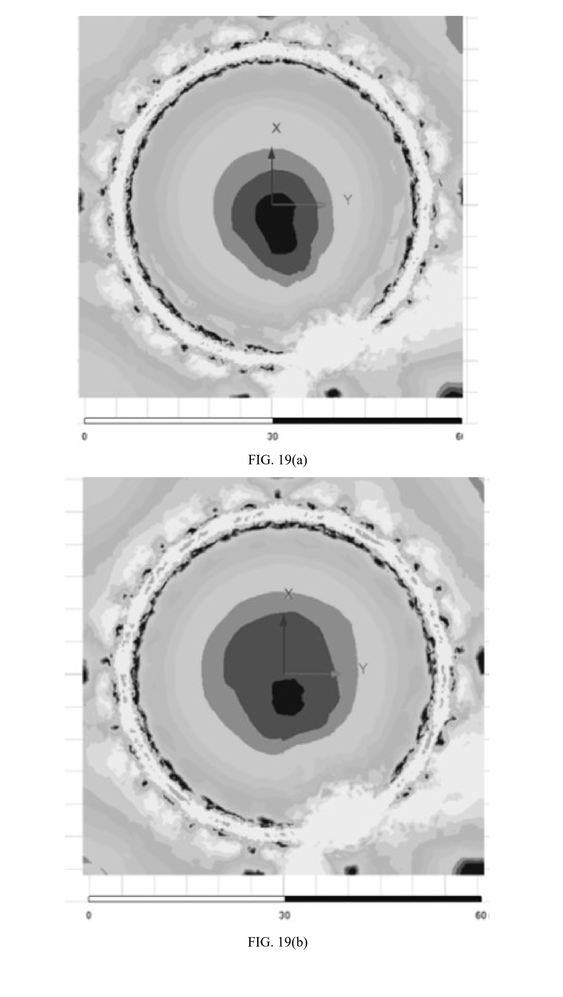

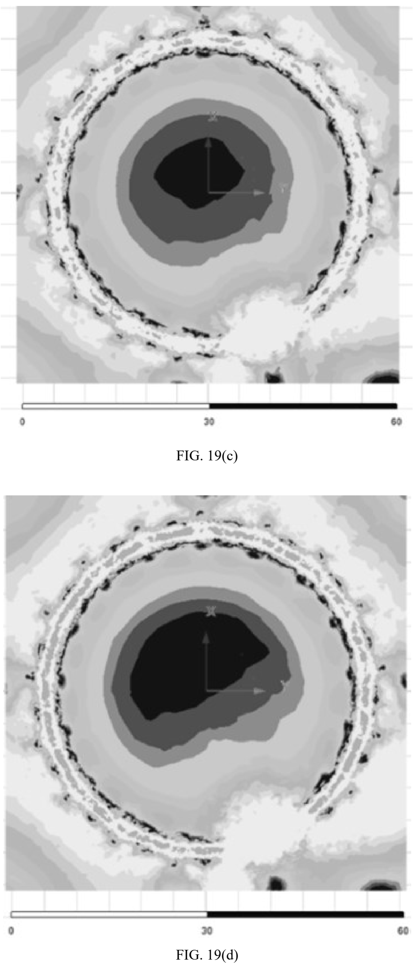

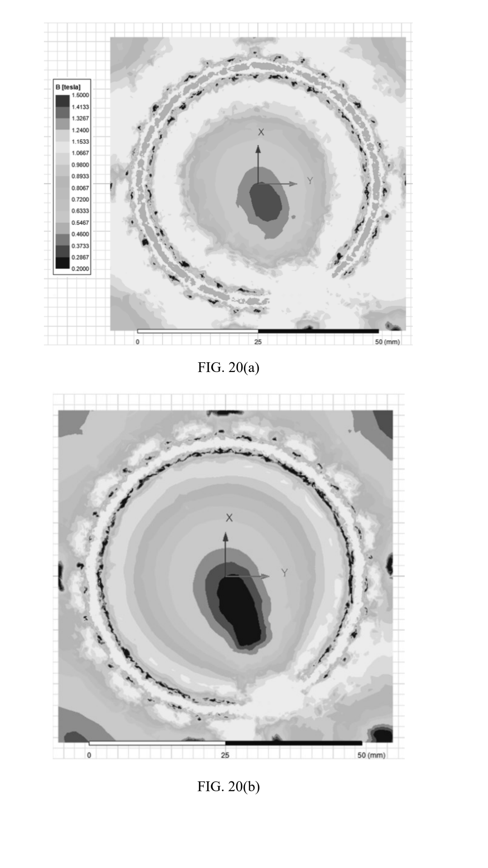

FIGS. 19(a) to 19(d) show a magnetic field distribution cloud map of the receiver-side magnetic core 412 in each of the embodiment 2, the embodiment 4, the embodiment 5, and the embodiment 7. FIGS. 20(a) and FIG. 20(b) show a magnetic field distribution cloud map of the receiver-side magnetic core 412 in each of the control embodiment 1 and the control embodiment 2.

According to the test results of the embodiments 1 to 7, the control embodiment 1, and the control embodiment 2 shown in Table 1, when the magnetic shielding assembly 100 includes only the first magnetic shielding member 10 (control embodiment 1) or the magnetic shielding assembly 100 is the integrally formed one-piece structure (control embodiment 2), the bias magnetic field within the receiver-side magnetic core 412 may be relatively large. Compared to the integrally formed one-piece magnetic shielding assembly 100 in the control embodiment 2, when the first magnetic shielding member 10 has the gap with the second magnetic shielding member 20 and the gap with the third magnetic shielding member 30 (embodiments 1 to 7), the bias magnetic field within the receiver-side magnetic core 412 may be smaller in size. As the first gap 101 and the second gap 102 gradually increase in size, the bias magnetic field within the receiver-side magnetic core 412 firstly decreases gradually and then increases gradually. When both the first gap 101 and the second gap 102 are 100 µm, the bias magnetic field within the receiver-side magnetic core 412 is minimal. When the first gap 101 and the second gap 102 are in a range of 20 µm to 400 µm, the magnetic shielding assembly 100 exhibits optimal magnetic shielding performance, and the bias magnetic field generated within the receiver-side magnetic core 412 may be better reduced, and the wireless charging efficiency may be increased.

According to the test results for the embodiments 1 to 7, the control embodiment 1, and the control embodiment 2 in Table 1, when the magnetic shielding assembly 100 includes only the first magnetic shielding member 10 (control embodiment 1), the self-inductance Lp of the transmitter-side wireless charging module 310, the self-inductance Ls of the receiver-side wireless charging module 410, the mutual inductance M between the transmitter-side wireless charging module 310 and the receiver-side wireless charging module 410, and a M/Lp ratio are all relatively small. When the magnetic shielding assembly 100 includes the first magnetic shielding member 10, the second magnetic shielding member 20, and the third magnetic shielding member 30, and when the first magnetic shielding member 10, the second magnetic shielding member 20, and the third magnetic shielding member 30 are integrally formed as a one-piece structure (control embodiment 2), the self-inductance Lp of the transmitter-side wireless charging module 310, the self-inductance Ls of the receiver-side wireless charging module 410, the mutual inductance M between the transmitter-side wireless charging module 310 and the receiver-side wireless charging module 410, and the M/Lp ratio are all increased. The increase in the M/Lp indicates that a voltage gain of the control embodiment 2 is improved compared to that in the control embodiment 1, such that the wireless charging efficiency may be increased.

When the first magnetic shielding member 10 is spaced apart from the second magnetic shielding member 20 and the third magnetic shielding member 30, as the first gap 101 and the second gap 102 increase in size, the self-inductance Lp of the transmitter-side wireless charging module 310, the self-inductance Ls of the receiver-side wireless charging module 410, and the mutual inductance M between the transmitter-side wireless charging module 310 and receiver-side wireless charging module 410 are all gradually increased. The ratio M/Lp initially increases gradually and then gradually decreases.

According to the magnetic field distribution cloud maps of the receiver-side magnetic core 412 (FIGS. 19(a) to 19(d) and FIGS. 20(a) and 20(b)) from the embodiments 2, 4, 5, 7, the control embodiment 1, and the control embodiment 2, when only the first magnetic shielding member 10 is arranged (control embodiment 1) or the magnetic shielding assembly 100 is integrally formed as a one-piece structure (control embodiment 2), an area of a blue region at a center of the magnetic field distribution cloud map of the receiver-side magnetic core 412 is relatively small. This indicates that the areas with weak magnetic fields in Comparative Examples 1 and 2 are limited, indicating that regions with a small magnetic field in the control embodiment 1 and in the control embodiment 2 are relatively smaller, and the bias magnetic field generated by the receiver-side magnetic core 412 is relatively strong.

As the width s1 of the first gap 101 and the width s2 of the second gap 102 increase (as in the embodiments 2, 4, 5, and 7), the bias magnetic field within the magnet distribution ring 210 gradually increases, and the bias magnetic field outside the magnet distribution ring 210 gradually decreases. This is because the first magnetic shielding member 10, the second magnetic shielding member 20, and the third magnetic shielding member 30 are arranged to form a U shape, and the magnetic flux lines of the magnet 210 may be confined between the second magnetic shielding member 20 and the third magnetic shielding member 30. Therefore, as the first gap 101 and the second gap 102 increase in size, the biased magnetic field confined within the annular region of the magnetic shielding assembly 100 may be larger, and the biased magnetic field in a region outside the magnetic shielding assembly 100 may be smaller. Thus, the magnetic shielding assembly 100 of the present disclosure enables a magnetic flux density within the receiver-side magnetic core 412, which was originally at a higher saturation level, to be higher. However, the bias magnetic field within an inner effective region of the receiver-side magnetic core 412 may be reduced. In this way, the inductance and the coupling performance of the receiver-side magnetic core 412 may be improved, the anti-saturation performance of the receiver-side magnetic core 412 may be improved, and the wireless charging efficiency may be increased.

The terms "embodiment" and "implementation" used herein may imply that specific features, structures, or characteristics described in an embodiment may be included in at least one embodiment of the present disclosure. The phrase used at various sections in the specification does not necessarily refer to one same embodiment, nor independent or alternative embodiments that are mutually exclusive with other embodiments. It is explicitly and implicitly understood by any ordinary skilled artisan that the embodiments described herein may be combined with other embodiments. Furthermore, it should be understood that the features, structures, or characteristics described in various embodiments of the present disclosure may be arbitrarily combined with each other, as long as no conflict is caused, so as to form yet another embodiment that remains within the spirit and scope of the present disclosure.

At last, it should be noted that the above embodiments are provided to illustrate the technical solutions of the present disclosure and are not intended to limit the present disclosure. Although the present disclosure is described in detail with reference to the above embodiments, any ordinary skilled artisan may understand that modifications or equivalent replacements may be made to the technical solutions of the present disclosure, and modifications or equivalent replacements do not depart from the spirit and scope of the technical solutions of the present disclosure.

## Claims

1. A magnetic shielding assembly (100), **characterized by** comprising:
a first magnetic shielding member (10);
a second magnetic shielding member (20), disposed at a side of the first magnetic shielding member (10), wherein a first gap (101) is formed between the first magnetic shielding member (10) and the second magnetic shielding member (20); and
a third magnetic shielding member (30), disposed at a side of the first magnetic shielding member (10) opposite to the second magnetic shielding member (20), wherein a second gap (102) is formed between the first magnetic shielding member (10) and the third magnetic shielding member (30); and the first magnetic shielding member (10), the second magnetic shielding member (20), and the third magnetic shielding member (30) cooperatively define a receiving slot (103).

2. The magnetic shielding assembly (100) according to claim 1, wherein, a width s1 of the first gap (101) is within a range of 20 µm ≤ s1 ≤ 400 µm.

3. The magnetic shielding assembly (100) according to claim 1, wherein, a width s2 of the second gap (102) is within a range of 20 µm ≤ s2 ≤ 400 µm.

4. The magnetic shielding assembly (100) according to claim 1, wherein, along a direction in which the second magnetic shielding member (20), the first magnetic shielding member (10), and the third magnetic shielding member (30) are arranged, a width w1 of the first magnetic shielding member (10) is within a range of 2 mm ≤ w1 ≤ 10 mm.

5. The magnetic shielding assembly (100) according to claim 1, wherein, along a thickness direction of the magnetic shielding assembly (100), a height h1 of the first magnetic shielding member (10) is in a range of 0.05 mm ≤ h1 ≤ 2.5 mm; the thickness direction of the magnetic shielding assembly (100) intersects a direction in which the second magnetic shielding member (20), the first magnetic shielding member (10), and the third magnetic shielding member (30) are arranged.

6. The magnetic shielding assembly (100) according to claim 1, wherein, along a direction in which the second magnetic shielding member (20), the first magnetic shielding member (10), and the third magnetic shielding member (30) are arranged, a width w2 of the second magnetic shielding member (20) is in a range of 0.1 mm ≤ w2 ≤ 5 mm.

7. The magnetic shielding assembly (100) according to claim 1, wherein, along a thickness direction of the magnetic shielding assembly (100), a height h2 of the second magnetic shielding member (20) is within a range of 0.2 mm ≤ h2 ≤ 5 mm; the thickness direction of the magnetic shielding assembly (100) intersects with a direction in which the second magnetic shielding member (20), the first magnetic shielding member (10), and the third magnetic shielding member (30) are arranged.

8. The magnetic shielding assembly (100) according to claim 1, wherein, along a direction in which the second magnetic shielding member (20), the first magnetic shielding member (10), and the third magnetic shielding member (30) are arranged, a width w3 of the third magnetic shielding member (30) is within a range of 0.1 mm ≤ w3 ≤ 5 mm.

9. The magnetic shielding assembly (100) according to claim 1, wherein, along a thickness direction of the magnetic shielding assembly (100), a height h3 of the third magnetic shielding member (30) is within a range of 0.2 mm ≤ h3 ≤ 5 mm; the thickness direction of the magnetic shielding assembly (100) intersects with a direction in which the second magnetic shielding member (20), the first magnetic shielding member (10), and the third magnetic shielding member (30) are arranged.

10. The magnetic shielding assembly (100) according to claim 1, wherein, each of the first magnetic shielding member (10), the second magnetic shielding member (20), and the third magnetic shielding member (30) is an annular structure; the first magnetic shielding member (10) surrounds an outer periphery of the second magnetic shielding member (20), and the third magnetic shielding member (30) surrounds an outer periphery of the first magnetic shielding member (10); the magnetic shielding assembly (100) comprises a notch at which the second magnetic shielding member (20), the first magnetic shielding member (10), and the third magnetic shielding member (30) are discontinuous.

11. The magnetic shielding assembly (100) according to claim 10, wherein, along a circumference of the magnetic shielding assembly (100), a width w of the gap is in a range of 0.1 mm ≤ w ≤ 50 mm.

12. The magnetic shielding assembly (100) according to claim 10, wherein, each of the first magnetic shielding member (10), the second magnetic shielding member (20), and the third magnetic shielding member (30) is an annular structure; and an inner diameter Ri of the second magnetic shielding member (20) is within a range of 15 mm ≤ Ri ≤ 30 mm.

13. A magnetic attraction assembly (200), comprising:
the magnetic shielding assembly (100) according to any one of claims 1-12; and
a magnet (210) received in the receiving slot (103) of the magnetic shielding assembly (100).

14. A wireless charging device, comprising:
a transmitter-side wireless charging module (310); and
a magnetic attraction assembly (200) according to claim 13, wherein the magnetic attraction assembly (200) surrounds an outer periphery of the transmitter-side wireless charging module (310).

15. An electronic device, comprising:
a receiver-side wireless charging module (410); and
a magnetic attraction assembly (200) according to claim 13, wherein the magnetic attraction assembly (200) surrounds an outer periphery of said receiver-side wireless charging module (410).
